# EUROPÄISCHE PATENTSCHRIFT

(11) **EP 0 839 386 B1**
(45) Veröffentlichungstag und Bekanntmachung des Hinweises auf die Patenterteilung: **04.10.2000**
(21) Anmeldenummer: 96920735.6
(22) Anmeldetag: 02.07.1996
(51) Int. Cl.: H01L 21/225, H01L 21/336

(54) **VERFAHREN ZUR HERSTELLUNG EINES MOS-TRANSISTORS**
METHOD OF PRODUCING AN MOS TRANSISTOR
PROCEDE DE FABRICATION D'UN TRANSISTOR MOS

(30) Priorität: 18.07.1995 DE 19526184
(43) Veröffentlichungstag der Anmeldung: 06.05.1998
(73) Patentinhaber: SIEMENS AKTIENGESELLSCHAFT, 80333 München (DE)
(72) Erfinder: SCHWALKE, Udo, D-84431 Heldenstein (DE)
(86) Internationale Anmeldenummer: DE9601174
(87) Internationale Veröffentlichungsnummer: WO9704480

(56) Entgegenhaltungen:
- US-A- 4 945 070
- EXTENDED ABSTRACTS, Bd. 87-2, 18.Oktober 1987, PRINCETON, NEW JERSEY US, Seiten 978-979, XP002015862 SATO Y ET AL: "ENHANCED BORON DIFFUSION THROUGH THIN SILICON DIOXIDE IN WET OXYGEN ATMOSPHERE"
- IEEE TRANSACTIONS ON ELECTRON DEVICES, Bd. 40, Nr. 12, 1.Dezember 1993, Seiten 2264-2271, XP000453715 SAITO M ET AL: "P-MOSFET'S WITH ULTRA-SHALLOW SOLID-PHASE-DIFFUSED DRAIN STRUCTURE PRODUCED BY DIFFUSION FROM BSG GATE-SIDEWALL"

## Beschreibung

Für batteriebetriebene Schaltungsanwendungen sowie für Logikschaltungen mit hoher Packungsdichte werden zunehmend MOS-Transistoren eingesetzt, die mit Versorgungsspannungen V_{dd} < 2 Volt betrieben werden. Um bei derartigen Versorgungsspannungen eine ausreichende Stromergiebigkeit (performance) zu gewährleisten, müssen Gatelängen und Einsatzspannungen entsprechend skaliert werden. Typische Gatelängen von derartigen MOS-Transistoren liegen unter ¼ µm. Die Einsatzspannungen Vₜ sind < 0,3 Volt. Damit sind hohe Anforderungen an das Kurzkanalverhalten der MOS-Transistoren verknüpft. Diese Anforderungen bedingen flache Source/Drain-Gebiete mit einer Tiefe unter 100 nm und eine Technologie mit bezüglich der Austrittsarbeit optimierten Gateelektroden. Zur Optimierung der Austrittsarbeit der Gateelektroden werden üblicherweise n⁺-dotierte Polysilizium-Gateelektroden für n-Kanal-MOS-Transistoren und p⁺-dotierte Gateelektroden aus Polysilizium für p-Kanal-MOS-Transistoren verwendet (sogenannte Dual-Workfunction Gate-Technologie).

Da in der Dual-Workfunction Gate-Technologie die Gateelektrode aus Polysilizium und die Source/Drain-Gebiete des jeweiligen Transistors vom gleichen Leitfähigkeitstyp dotiert sind, können Gateelektrode und Source/Drain-Gebiete im Prinzip gleichzeitig durch eine Ionenimplantation dotiert werden. Da jedoch auch bei MOS-Transistoren mit flachen Source/Drain-Gebieten die Gateelektrode hochdotiert sein muß, um Einbußen in der Stromergiebigkeit durch Dotierstoffabreicherung im Gate (Gatedepletion) zu vermeiden (siehe zum Beispiel C. Y. Wong et al, IEDM '88, p 238), sind die Anforderungen für die Bildung flacher Source/Drain-Gebiete und hochdotierter Gateelektroden durch Implantation so unterschiedlich, daß diese Möglichkeit für MOS-Transistoren mit flachen Source/Drain-Gebieten ausscheidet.

Bei der Ionenimplantation kommt es durch verschiedene Effekte zu einer Verbreiterung des Implantationsprofils, die die minimale Tiefe flacher dotierter Gebiete begrenzt. Durch den sogenannten Channeling-Effekt dringt ein nicht vernachlässigbarer Teil des Dotierstoffes tiefer in den Kristall ein, als es der Reichweite der Ionen entspricht. Der dabei gebildete Channeling-Tail verbreitert das Implantationsprofil. Da dieser Effekt eine Folge der Regelmäßigkeiten im Kristallgitter ist, ist vorgeschlagen worden (siehe R. B. Fair, IEDM '87, p 260), vor der Implantation von Dotierstoff durch eine zusätzliche Implantation mit Silizium oder Germanium den Bereich in Silizium, in dem das dotierte Gebiet gebildet wird, amorph zu machen (sogenannte Pre-Amorphisierung). Die bei der Implantation von Silizium oder Germanium erzeugten Kristallschäden müssen nach der Dotierung in zusätzlichen Temperschritten ausgeheilt werden.

Ferner wird das Implantationsprofil dadurch verbreitert, daß bei der Implantation Siliziumzwischengitteratome gebildet werden, die eine Erhöhung der Diffusionsgeschwindigkeit insbesondere bei den Dotierstoffen Bor und Phosphor hervorrufen (siehe P. B. Griffin et al, IEDM '93, p 295).

In bekannten Verfahren zur Herstellung von MOS-Transistoren mit flachen Source/Drain-Gebieten wird die Dotierung von Gateelektrode und Source/Drain-Gebieten in zwei Schritten optimiert.

Aus T. Eguchi et al, IEDM '93, p 831, ist ein Verfahren bekannt, bei dem die Gateelektroden aus in situ dotiertem Polysilizium gebildet werden. Nach Strukturierung der Gateelektroden werden die Source/Drain-Gebiete durch Implantation gebildet. In diesem Prozeß ergibt sich ein Mehraufwand von 1 bis 2 Photolackmasken.

Aus D. C. M. Yu et al, IEDM '94, p 489 ist ein Verfahren bekannt, bei dem die Source/Drain-Gebiete und die Gateelektrode jeweils in einem eigenen Implantationsschritt gebildet werden. Bei der Source/Drain-Implantation wird der Ionenstrahl gewinkelt und mit extrem niedriger Energie eingestrahlt. Für jede der Implantationen wird eine eigene Maske benötigt.

Aus T. Hori, IEDM '94, p 75, ist ein Verfahren zur Herstellung eines MOS-Transistors mit flachen Source/Drain-Gebieten bekannt, bei dem die Tiefe der Source/Drain-Gebiete durch eine zusätzliche, gewinkelte Gegenimplantation nachträglich reduziert wird. Bei dieser Gegenimplantation ist die Gateelektrode durch eine zusätzliche Maske abgedeckt.

Aus M. Togo et al, VLSI Symp. '94, p 21, ist ein Verfahren zur Herstellung eines MOS-Transistors bekannt, bei dem auf einem mit einem Gateoxid versehenen Halbleitersubstrat zunächst eine Gateelektrode hergestellt wird. Seitlich der Gateelektrode sind Gebiete, in denen Source/Drain-Gebiete vorgesehen sind, mit dem Gateoxid bedeckt. Anschließend wird eine Polysiliziumschicht abgeschieden, die die Gebiete für die Source/Drain-Gebiete und die Gateelektrode überdeckt. Durch Implantation wird die Polysiliziumschicht p⁺-dotiert. Durch Diffusion werden anschließend die Source/Drain-Gebiete gebildet. Schließlich wird die Polysiliziumschicht entfernt. Auch hier wird die Gateelektrode vor der Erzeugung der Source/Drain-Gebiete dotiert.

Der Erfindung liegt das Problem zugrunde, ein Verfahren zur Herstellung eines MOS-Transistors anzugeben, mit dem flache Source/Drain-Gebiete herstellbar sind und bei dem der Prozeßaufwand, insbesondere bezüglich der benötigten Masken, gegenüber den bekannten Verfahren reduziert ist.

Dieses Problem wird erfindungsgemäß gelöst durch ein Verfahren nach Anspruch 1. Weitere Ausgestaltungen der Erfindung gehen aus den übrigen Ansprüchen hervor.

In dem erfindungsgemäßen Verfahren werden die Source/Drain-Gebiete und die Gateelektrode gleichzeitig durch Ausdiffusion aus einer dotierten Schicht gebildet. Die unterschiedlichen Anforderungen an das Dotierstoffprofil in den Source/Drain-Gebieten und der Gateelektrode werden dadurch erfüllt, daß an der Oberfläche der Source/Drain-Gebiete eine permeable Diffusionsbarriere angeordnet ist, durch die die Diffusion hindurch erfolgt. Als Diffusionsbarriere ist zum Beispiel ein dünnes Grenzflächenoxid in einer Dicke zwischen 0,1 und 10 nm geeignet. Durch die Diffusionsbarriere wird die Ausdiffusion in das Halbleitersubstrat vermindert; sie wird jedoch nicht vollständig blockiert. Da die dotierte Schicht andererseits direkt auf der Oberfläche der Siliziumstruktur angeordnet ist, findet bei der Bildung der Gateelektrode durch Dotierung aus der Siliziumstruktur eine unbehinderte Ausdiffusion statt, so daß hier eine hohe Dotierung, vorzugsweise im Bereich 5 x 10¹⁹ bis 5 x 10²¹ Atome/cm³ erzielt wird.

Das Halbleitersubstrat besteht vorzugsweise mindestens im Bereich des MOS-Transistors aus monokristallinem Silizium. Dabei kann es sich sowohl um eine monokristalline Siliziumscheibe als auch um die Siliziumschicht eines SOI-Substrats handeln.

Die dotierte Schicht kann durch Abscheidung einer undotierten Schicht, zum Beispiel aus Polysilizium, und anschließende Dotierung durch Diffusion oder Implantation gebildet werden. Zur Bildung der dotierten Schicht kann eine Doppelschicht aus undotiertem, amorphem oder polykristallinem Silizium und dotiertem Glas, zum Beispiel PSG oder BSG, erzeugt werden. Das dotierte Glas kann dabei durch Abscheidung oder Belegung gebildet werden. Vorzugsweise wird die dotierte Schicht durch in situ dotierte Abscheidung von dotiertem Silizium oder dotiertem Glas gebildet. Vorzugsweise wird die dotierte Schicht aus dotiertem Polysilizium gebildet, da in diesem Fall bei der Ausdiffusion des Dotierstoffs eine Aufoxidation der dotierten Schicht möglich ist. Außerdem ist die Erzeugung von dotierten Polysiliziumschichten ein in MOS-Technologien üblicher Schritt.

Die Bildung der dotierten Schicht durch in situ dotierte Abscheidung von zum Beispiel dotiertem Polysilizium oder dotiertem Glas hat den Vorteil, daß zur Bildung der Source/Drain-Gebiete und der Gateelektrode keine Implantationsschritte erforderlich sind. Damit entfallen die in den aus dem Stand der Technik bekannten Verfahren mit der Implantation verbundenen Probleme wie Channeling oder erhöhte Implantationsgeschwindigkeit durch Kristallschäden. Damit ist es in dem erfindungsgemäßen Verfahren auch möglich, flache Gatestrukturen mit einer Dicke der Gateelektrode unter 150 nm herzustellen. Derartig flache Gatestrukturen führen zu einer Verringerung der Topologie, womit Abbildungsfehler und Ätztoleranzen bei der Photolithographie und der Ätztechnik zur Herstellung der Strukturen minimiert werden. Dieses ist besonders wichtig bei Strukturgrößen < ¼ µm. Ferner sind bei einer verringerten Topologie die Stufen an der Oberfläche der Struktur geringer, so daß die Anforderungen an eine abschließende Planarisierung zum Beispiel mit BPSG geringer sind. Verfließtemperatur und Verfließzeiten können aufgrund der verringerten Stufenhöhe reduziert werden. Damit ist die gesamte Struktur einem verringerten thermischen Budget ausgesetzt, was sich auf die erzielbaren Source/Drain-Dotierstoffprofile günstig auswirkt.

Es liegt im Rahmen der Erfindung, die Siliziumstruktur und das Gatedielektrikum so zu bilden, daß zwischen der Siliziumstruktur und dem Halbleitersubstrat eine Dotierstoffbarriere besteht. Dieses erfolgt zum Beispiel dadurch, daß zwischen dem Gatedielektrikum und der Siliziumstruktur eine Schicht aus stickstoffhaltigem Silizium erzeugt wird, die gleichzeitig mit der Siliziumstruktur strukturiert wird. Alternativ wird das Gatedielektrikum aus einem nitridierten Oxid oder einem Hochtemperatur RTO-SiO₂ gebildet. Stickstoffhaltiges Silizium sowie nitridiertes Oxid bzw. Hochtemperatur RTO-SiO₂ haben die Eigenschaft, für Dotierstoff undurchdringlich zu sein. Diese Ausführungsform hat den Vorteil, daß auch bei einer Bildung der dotierten Schicht durch Abscheidung einer undotierten Schicht und anschließende Implantation ein Eindringen von Dotierstoff durch die Siliziumstruktur und das Gatedielektrikum in den Kanalbereich, zum Beispiel aufgrund des Channeling-Effektes, verhindert wird.

Vorzugsweise wird die permeable Diffusionsbarriere an der Oberfläche der Source/Drain-Gebiete selbstjustiert gebildet. Dazu wird die Oberfläche der Siliziumstruktur mit einer Si₃N₄-Abdeckung versehen. Anschließend wird eine thermische Oxidation durchgeführt, bei der die permeable Diffusionsbarriere als SiO₂-Schicht an der Oberfläche der Gebiete, an denen Source/Drain-Gebiete vorgesehen sind, gebildet wird. Schließlich wird die Si₃N₄-Abdeckung selektiv zu SiO₂ entfernt.

Durch eine ganzflächige Implantation mit F, Ar, Xe oder Si kann die Durchlässigkeit der permeablen Diffusionsbarriere beeinflußt werden. Die Diffusionsgeschwindigkeit durch die Diffusionsbarriere nimmt in diesem Fall zu. Diese Maßnahme führt zu einem größeren Prozeßfenster bezüglich der Dicke der permeablen Diffusionsbarriere.

Im folgenden wird die Erfindung anhand der Figuren und eines Ausführungsbeispiels näher erläutert.
- Figur 1: zeigt ein Halbleitersubstrat mit einer Mehrfachschicht.
- Figur 2: zeigt das Halbleitersubstrat nach Strukturierung der Mehrfachschicht zur Bildung eines Gatedielektrikums und einer Siliziumstruktur.
- Figur 3: zeigt das Halbleitersubstrat nach einer thermischen Oxidation.
- Figur 4: zeigt das Halbleitersubstrat nach einer Spacerätzung.
- Figur 5: zeigt das Halbleitersubstrat nach Bildung einer permeablen Diffusionsbarriere.
- Figur 6: zeigt das Halbleitersubstrat nach Entfernung einer Si₃N₄-Abdeckung.
- Figur 7: zeigt das Halbleitersubstrat nach Aufbringen einer dotierten Schicht.

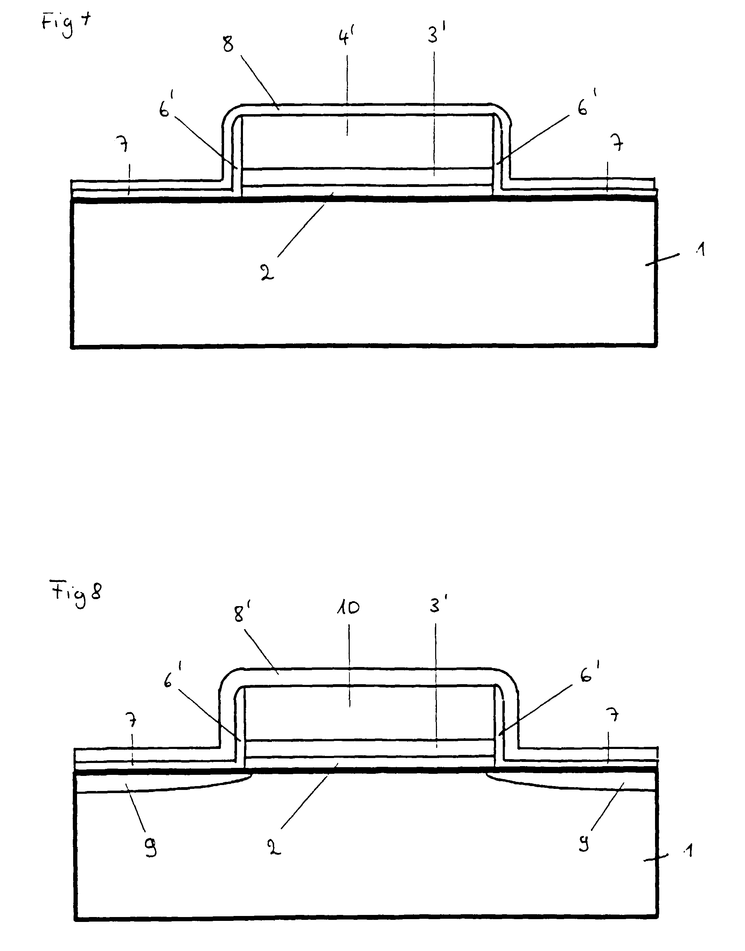

- Figur 8: zeigt das Halbleitersubstrat nach Fertigstellung eines MOS-Transistors.

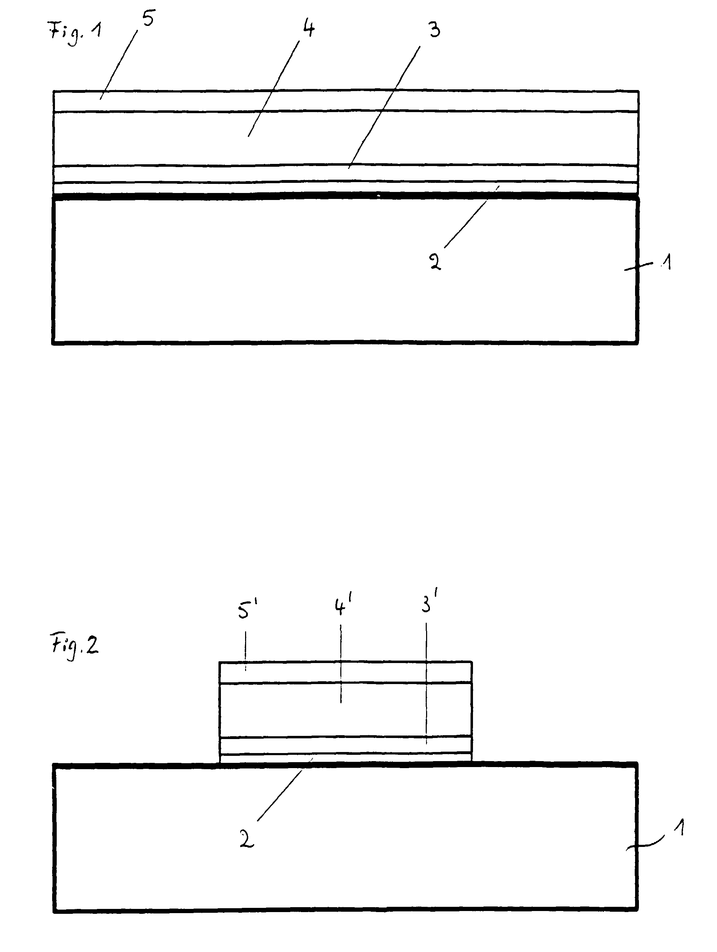

Auf ein Substrat 1 aus zum Beispiel monokristallinem Silizium wird ein Gateoxid 2 aufgebracht (siehe Figur 1). Das Gateoxid 2 wird in einer Dicke von zum Beispiel 3 bis 10 nm durch thermische Oxidation gebildet.

Auf das Gateoxid 2 wird eine stickstoffhaltige Siliziumschicht 3 aufgebracht. Die stickstoffhaltige Siliziumschicht 3 wird in einer Dicke von 2 bis 20 nm erzeugt. Sie wird durch reaktives Sputtern zu amorphem SiN, durch in situ dotiertes Abscheiden von stickstoffdotiertem Polysilzium oder durch undotiertes Abscheiden und anschließendes Implantieren von Polysilizium gebildet.

Auf die stickstoffhaltige Siliziumschicht 3 wird eine Siliziumschicht 4 aufgebracht. Die Siliziumschicht 4 wird in einer Dicke von zum Beispiel 20 bis 150 nm erzeugt. Sie wird durch Abscheidung von amorphem Silizium oder Polysilizium gebildet. Vorzugsweise wird sie aus amorphem Silizium wegen der günstigeren Textur in bezug auf Dotierstoffverteilung und Strukturierbarkeit erzeugt.

Auf die Siliziumschicht 4 wird eine Si₃N₄-Deckschicht 5 aufgebracht. Die Si₃N₄-Deckschicht 5 wird in einer Dicke von zum Beispiel 2 bis 20 nm aufgebracht.

Mit Hilfe photolithographischer Prozeßschritte und einer Photolackmaske wird der aus stickstoffhaltiger Siliziumschicht 3, Siliziumschicht 4 und Si₃N₄-Deckschicht 5 gebildete Schichtaufbau strukturiert. Dabei wird auch das Gateoxid 2 strukturiert. Dabei wird aus der stickstoffhaltigen Siliziumschicht 3 eine Dotierstoffbarriere 3', aus der Siliziumschicht 4 eine Siliziumstruktur 4' und aus der Si₃N₄-Deckschicht 5 eine Si₃N₄-Abdeckung 5'. Die Si₃N₄-Abdeckung 5', die Siliziumstruktur 4', die Dotierstoffbarriere 3' sowie das Gateoxid 2 weisen gemeinsame Flanken auf. Außerhalb davon ist die Oberfläche des Substrats 1 mindestens in Gebieten, in den Source/Drain-Gebiete gebildet werden, freigelegt (siehe Figur 2).

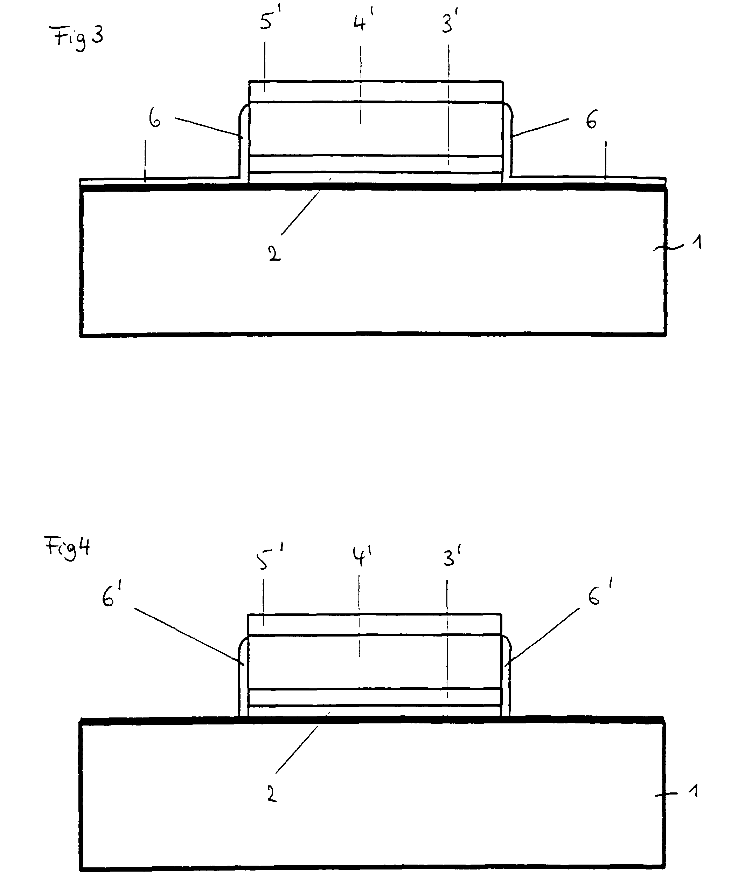

Nach Entfernen der Photolackmaske (nicht dargestellt) wird eine thermische Oxidation zur Bildung einer SiO₂-Schicht 6 durchgeführt. Die SiO₂-Schicht 6 weist eine Dicke von 5 bis 20 nm auf und ist an den freiliegenden Flanken der Siliziumstruktur 4' und der Dotierstoffbarriere 3' sowie auf der freiliegenden Oberfläche des Substrats 1 angeordnet (siehe Figur 3). Die Oberfläche der Siliziumstruktur 4' ist dabei durch die Si₃N₄-Abdeckung 5' vor der Oxidation geschützt.

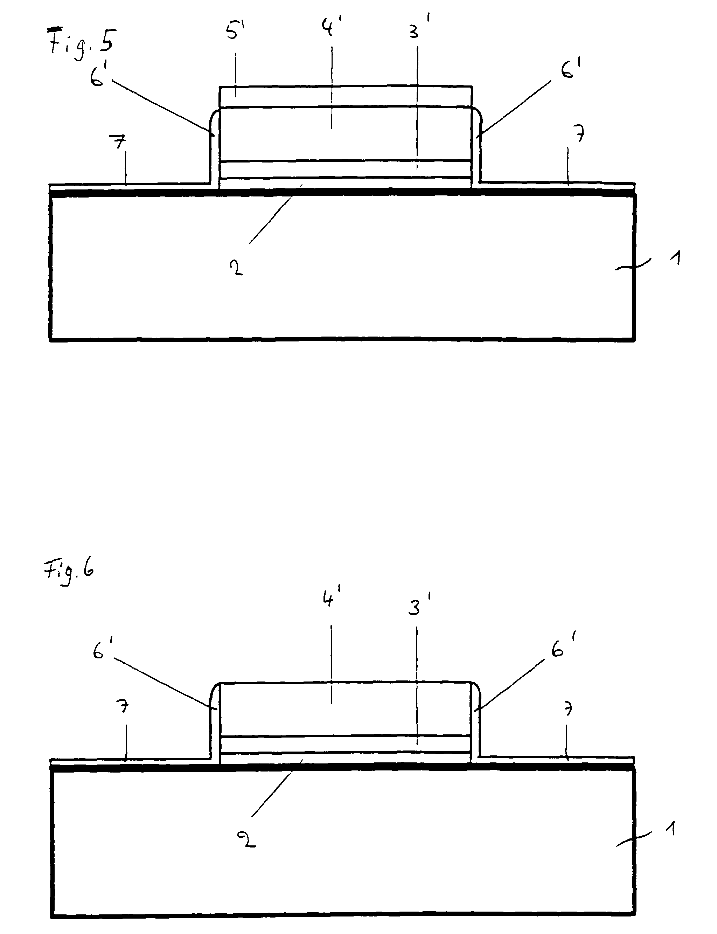

Durch eine anisotrope Trockenätzung, zum Beispiel mit CHF₃/Ar Gas werden horizontale Teile der SiO₂-Schicht 6 entfernt. Dabei bilden sich an den Flanken der Siliziumstruktur 4', der Dotierstoffbarriere 3' und des Gateoxids 2 SiO₂-Spacer 6'. In den Gebieten, in denen Source/Drain-Gebiete hergestellt werden, ist dagegen die Oberfläche des Substrats 1 freigelegt (siehe Figur 4).

Durch eine gezielte thermische Oxidation bei zum Beispiel 500 bis 800°C wird auf der freiliegenden Oberfläche des Substrats 1 eine permeable Diffusionsbarriere 7 als Grenzflächenoxid gebildet (siehe Figur 5). Die permeable Diffusionsbarriere wird in einer Dicke von 0,1 bis 10 nm gebildet. Anschließend wird die Si₃N₄-Abdeckung 5' naßchemisch zum Beispiel mit H₃PO₄ entfernt. Bei der Entfernung der Si₃N₄-Abdeckung 5' ist es wesentlich, daß eine hohe Selektivität in bezug auf SiO₂ vorliegt, damit die permeable Diffusionsbarriere 7 eine definierte Dicke aufweist (siehe Figur 6).

Anschließend wird ganzflächig eine dotierte Schicht 8 aufgebracht. Die dotierte Schicht 8 wird zum Beispiel durch in situ dotierte Abscheidung von amorphem Silizium oder Polysilizium erzeugt. Die dotierte Schicht 8 ist zum Beispiel bordotiert mit einer Dotierstoffkonzentration von 10²⁰ bis 10²² cm⁻³. Die dotierte Schicht 8 wird in einer Dicke von zum Beispiel 10 bis 100 nm abgeschieden (siehe Figur 7).

Durch einen Temperschritt in oxidierender Atmosphäre, zum Beispiel in H₂O bei 1000°C, wird aus der dotierten Schicht 8 Dotierstoff in das Substrat 1 sowie in die Siliziumstruktur 4' eingetrieben. Dabei werden im Substrat 1 p-dotierte Source/Drain-Gebiete 9 erzeugt. Gleichzeitig wird durch Dotierung der Siliziumstruktur 4' eine p⁺-dotierte Gateelektrode 10 gebildet. Ferner wird aus der dotierten Schicht 8 durch Aufoxidation eine SiO₂-Schicht 8'. Die permeable Diffusionsbarriere 7 bewirkt, daß die Tiefe der Source/Drain-Gebiete 9 etwa 60 nm beträgt bei einer Dotierstoffkonzentration von etwa 10¹⁹ cm⁻³.

Gleichzeitig wird in der Gateelektrode 10 eine Dotierstoffkonzentration von 10²⁰ cm⁻³ eingestellt. Der Dotierstoff ist in der Gateelektrode 10 homogen verteilt. Die Dotierstoffbarriere 3' verhindert beim Eintreiben des Dotierstoffs ein Eindringen des Dotierstoffs in den Kanalbereich des MOS-Transistors.

Das Gateoxid 2 kann alternativ aus nitridiertem Oxid oder einem RTO-SiO₂ gebildet werden. Diese Materialien wirken als Dotierstoffbarriere, so daß in diesem Fall die Dotierstoffbarriere 3' entfallen kann. Nitridiertes Oxid wird durch Oxidation bei 1100°C, 5 bis 60 s in O₂-Atmosphäre, Abscheidung von Si₃N₄ bei 900 bis 1100°C unter Verwendung von NH₃ und/oder N₂O und anschließende Reoxidation bei 1150°C gebildet. RTO-SiO₂ wird durch Oxidation bei 1100°C 5 bis 60 s in O₂-Atmosphäre und anschließende Temperung bei 1000°C gebildet.

Die Diffusion des Dotierstoffes durch die permeable Diffusionsbarriere 7 kann dadurch optimiert werden, daß vor der Ausdiffusion eine ganzflächige Implantation mit F, Ar, Xe oder Si durchgeführt wird. Diese Ionenimplantation erzeugt Zwischengitteratome, die eine Diffusion beschleunigen.

Schließlich wird der MOS-Transistor durch Abscheidung einer planarisierenden Schicht zum Beispiel aus BPSG und Planarisierung, sowie Kontaktlochätzung und Metallisierung fertiggestellt (nicht dargestellt).

Alternativ kann die SiO₂-Schicht 8' nach der Bildung der Source/Drain-Gebiete anisotrop geätzt werden, wobei die Oberfläche der Source/Drain-Gebiete 9 und der Gateelektrode 10 freigelegt wird. Die Oberfläche der Source/Drain-Gebiete 9 und der Gateelektrode 10 wird dann selektiv mit Metallsilizid versehen. Dieses erfolgt zum Beispiel in einem Salicide-Prozeß.

Die Erfindung wurde am Beispiel eines PMOS-Transistors beschrieben, sie ist ebenso auf einen NMOS-Transistor übertragbar. In diesem Fall wird als Dotierstoff Arsen oder Phosphor verwendet. Die Dicke des als permeable Diffusionsbarriere verwendeten Grenzflächenoxids beträgt in diesem Fall 0,1 bis 1 nm.

## Patentansprüche

1. Verfahren zur Herstellung eines MOS-Transistors,
- bei dem auf einem Halbleitersubstrat (1) ein Gatedielektrikum (2) und eine Siliziumstruktur (4') so erzeugt werden, daß die Oberfläche des Halbleitersubstrats mindestens in Gebieten, in denen Source/Drain-Gebiete vorgesehen sind, freiliegt,
- bei dem mindestens an der Oberfläche der Gebiete für die Source/Drain-Gebiete eine permeable Diffusionsbarriere (7) erzeugt wird,
- bei dem eine dotierte Schicht (8) gebildet wird, die die Oberfläche der permeable Diffusionsbarriere (7) im Bereich der Gebiete für die Source/Drain-Gebiete und die Oberfläche der Siliziumstruktur (4') bedeckt,
- bei dem die Siliziumstruktur (4') zur Bildung einer Gateelektrode (10) durch Ausdiffusion aus der dotieren Schicht (8) dotiert wird und die Source/Drain-Gebiete (9) gleichzeitig durch Ausdiffusion aus der dotierten Schicht (8) gebildet werden, wobei der Dotierstoff durch die permeable Diffusionsbarriere (7) hindurchdiffundiert.

2. Verfahren nach Anspruch 1,
bei dem die Siliziumstruktur (4') und das Gatedielektrikum (2) so gebildet werden, daß zwischen der Siliziumstruktur (4') und dem Halbleitersubstrat (1) eine Dotierstoffbarriere wirksam wird.

3. Verfahren nach Anspruch 2,
bei dem zwischen dem Gatedielektrikum (2) und der Siliziumstruktur (4') eine stickstoffhaltige Siliziumschicht (3) als Dotierstoffbarriere erzeugt wird.

4. Verfahren nach Anspruch 2,
bei dem das Gatedielektrikum aus einem nitridiertem Oxid oder einem Hochtemperatur-RTO-SiO₂ gebildet wird, so daß das Gatedielektrikum (2) als Dotierstoffbarriere wirkt.

5. Verfahren nach einem der Ansprüche 1 bis 4,
- bei dem an der Oberfläche der Siliziumstruktur (4') eine Si₃N₄-Abdeckung (5') gebildet wird,
- bei dem zur Bildung der permeable Diffusionsbarriere (7) eine thermische Oxidation durchgeführt wird, bei der an der Oberfläche der Gebiete für die Source/Drain-Gebiete eine SiO₂-Schicht gebildet wird,
- bei dem die Si3N4-Abdeckung (5') selektiv zu SiO₂ entfernt wird.

6. Verfahren nach einem der Ansprüche 1 bis 5,
bei dem vor der Ausdiffusion zur Bildung der Source/Drain-Gebiete (9) und der Gateelektrode (10) eine ganzflächige Implantation mit F, Ar, Xe oder Si durchgeführt wird.

7. Verfahren nach einem der Ansprüche 1 bis 6,
bei dem die dotierte Schicht (8) durch in situ dotierte Abscheidung einer dotierten Siliziumschicht gebildet wird.

8. Verfahren nach Anspruch 7,
bei dem die Ausdiffusion aus der dotierten Siliziumschicht (8) so erfolgt, daß die dotierte Siliziumschicht gleichzeitig aufoxidiert wird.

## Claims

1. Method for fabricating a MOS transistor,
- in which a gate dielectric (2) and a silicon structure (4') are produced on a semiconductor substrate (1) in such a way that the surface of the semiconductor substrate is uncovered at least in regions in which source/drain regions are envisaged,
- in which a permeable diffusion barrier (7) is produced at least on the surface of the regions for the source/drain regions,
- in which a doped layer (8) is formed, which covers the surface of the permeable diffusion barrier (7) in the area of the regions for the source/drain regions and the surface of the silicon structure (4'),
- in which the silicon structure (4') is doped, for the purpose of forming a gate electrode (10), by outdiffusion from the doped layer (8) and the source/drain regions (9) are simultaneously formed by outdiffusion from the doped layer (8), the dopant diffusing through the permeable diffusion barrier (7).

2. Method according to Claim 1,
in which the silicon structure (4') and the gate dielectric (2) are formed in such a way that a dopant barrier becomes effective between the silicon structure (4') and the semiconductor substrate (1).

3. Method according to Claim 2,
in which a nitrogen-containing silicon layer (3) is produced as the dopant barrier between the gate dielectric (2) and the silicon structure (4').

4. Method according to Claim 2,
in which the gate dielectric is formed from a nitrided oxide or a high-temperature RTO SiO₂, with the result that the gate dielectric (2) acts as the dopant barrier.

5. Method according to one of Claims 1 to 4,
- in which an Si₃N₄ covering (5') is formed on the surface of the silicon structure (4'),
- in which a thermal oxidation is carried out in order to form the permeable diffusion barrier (7), during which thermal oxidation an SiO₂ layer is formed on the surface of the regions for the source/drain regions,
- in which the Si₃N₄ covering (5') is removed selectively with respect to SiO₂.

6. Method according to one of Claims 1 to 5,
in which whole-area implantation with F, Ar, Xe or Si is carried out prior to the outdiffusion for the purpose of forming the source/drain regions (9) and the gate electrode (10).

7. Method according to one of Claims 1 to 6,
in which the doped layer (8) is formed by the in situ-doped deposition of a doped silicon layer.

8. Method according to Claim 7,
in which the outdiffusion from the doped silicon layer (8) is carried out in such a way that the doped silicon layer is simultaneously oxidized.

## Revendications

1. Procédé de fabrication d'un transistor MOS
- dans lequel on produit un diélectrique de grille (2) et une structure en silicium (4') sur un substrat semi-conducteur (1) de manière à ce que la surface du substrat semi-conducteur soit dégagée au moins dans les régions dans lesquelles des zones source-drain sont prévues,
- dans lequel on produit une barrière de diffusion (7) perméable au moins sur la surface des régions pour les zones source-drain,
- dans lequel on forme une couche dopée (8) qui couvre la surface de la barrière de diffusion (7) perméable dans les régions pour les zones source-drain et la surface de la structure en silicium (4'),
- dans lequel la structure en silicium (4') est dopée par diffusion à partir de la couche dopée (8) en vue de la formation d'une électrode de grille (10), et les zones source-drain (9) sont formées simultanément par diffusion à partir de la couche dopée (8), l'agent de dopage diffusant à travers la barrière de diffusion (7) perméable.

2. Procédé selon la revendication 1,
dans lequel la structure en silicium (4') et le diélectrique de grille (2) sont formés de manière à ce qu'une barrière d'agent de dopage soit active entre la structure en silicium (4') et le substrat semi-conducteur (1).

3. Procédé selon la revendication 2, dans lequel une couche de silicium (3) contenant de l'azote est produite en tant que barrière d'agent de dopage entre le diélectrique de grille (2) et la structure en silicium (4').

4. Procédé selon la revendication 2, dans lequel le diélectrique de grille est formé d'un oxyde nitruré ou d'un SiO₂ RTO haute température, de manière à ce que le diélectrique de grille (2) agisse en tant que barrière d'agent de dopage.

5. Procédé selon l'une des revendications 1 à 4,
- dans lequel une couverture de Si₃N₄ (5') est formée sur la surface de la structure en silicium (4'),
- dans lequel, pour former la barrière de diffusion (7) perméable, on procède à une oxydation thermique au cours de laquelle une couche de SiO₂ est formée sur la surface des régions pour les zones source-drain,
- dans lequel la couverture de Si₃N₄ (5') est éliminée de manière sélective par rapport au SiO₂.

6. Procédé selon l'une des revendications 1 à 5, dans lequel on procède, avant la diffusion permettant de former les zones source-drain (9) et l'électrode de grille (10), à une implantation sur toute la surface avec F, Ar, Xe ou Si.

7. Procédé selon l'une des revendications 1 à 6, dans lequel la couche dopée (8) est formée par déposition dopée in situ d'une couche de silicium dopée.

8. Procédé selon la revendication 7, dans lequel la diffusion à partir de la couche de silicium (8) dopée se fait de manière à ce que la couche de silicium dopée soit simultanément oxydée.
